(19) **Europäisches Patentamt / European Patent Office / Office européen des brevets**

(11) **EP 4 653 887 A1**

(12) # EUROPÄISCHE PATENTANMELDUNG

(43) Veröffentlichungstag:
26.11.2025 Patentblatt 2025/48

(21) Anmeldenummer: 25176715.8

(22) Anmeldetag: 15.05.2025

(51) Internationale Patentklassifikation (IPC):
**G01R 31/36** (2020.01)   **G01R 31/367** (2019.01)
**G01R 31/374** (2019.01)   **G01R 31/382** (2019.01)

(52) Gemeinsame Patentklassifikation (CPC):
**G01R 31/382; G01R 31/3648; G01R 31/367; G01R 31/374;** G01R 31/392

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH LA MA MD TN**

(30) Priorität: 24.05.2024 DE 102024001688

(71) Anmelder: **Mercedes-Benz Group AG**
**70372 Stuttgart (DE)**

(72) Erfinder:
• **BACH, Tobias Clemens**
**70186 Stuttgart (DE)**
• **ARJONA ESTEBAN, Alhama**
**70186 Stuttgart (DE)**
• **WITZENHAUSEN, Heiko**
**73728 Esslingen (DE)**

(74) Vertreter: **Weller, Jürgen**
**Mercedes-Benz Intellectual Property GmbH & Co. KG**
**HPC H 512**
**70546 Stuttgart (DE)**

(54) **COMPUTERIMPLEMENTIERTES VERFAHREN ZUR SCHÄTZUNG DER VON EINER TRAKTIONSBATTERIE SPEICHERBAREN ELEKTRISCHEN ENERGIEMENGE, COMPUTERPROGRAMMPRODUKT, COMPUTERLESBARES SPEICHERMEDIUM UND FAHRZEUG**

(57) Die Erfindung betrifft ein computerimplementiertes Verfahren zur Schätzung der von einer Traktionsbatterie eines Fahrzeugs speicherbaren elektrischen Energiemenge (1), wobei eine fahrzeuginterne Recheneinheit zur Bestimmung der elektrischen Energiemenge (1) eine Batteriekapazität (2) der Traktionsbatterie mit dem Integral (3) der Batteriespannung (4) der Traktionsbatterie von einer unteren Ladezustandsgrenze (5) bis zu einer oberen Ladezustandsgrenze (6) multipliziert, wobei für die untere Ladezustandsgrenze (5) ein von der Alterung der Traktionsbatterie abhängiger Wert angenommen wird. Das erfindungsgemäße computerimplementierte Verfahren ist dadurch gekennzeichnet, dass die Recheneinheit die untere Ladezustandsgrenze (5) durch eine lineare Korrelation zum Verhältnis (7) der aktuellen maximalen Batteriekapazität zur ursprünglichen maximalen Batteriekapazität der Traktionsbatterie unter Berücksichtigung wenigstens eines Parameters bestimmt, wobei die von der Alterung abhängige Höhe des wenigstens einen Parameters (8.1, 8.2) durch Analyse historischer Batteriedaten von Lade- und/oder Entladevorgängen baugleicher Traktionsbatterien festgelegt wird.

Fig. 4

**Beschreibung**

Die Erfindung betrifft ein computerimplementiertes Verfahren zur Schätzung der von einer Traktionsbatterie eines Fahrzeugs speicherbaren elektrischen Energiemenge nach der im Oberbegriff von Anspruch 1 näher definierten Art sowie ein Computerprogrammprodukt, ein computerlesbares Speichermedium und ein Fahrzeug.

Der Anteil batterieelektrisch angetriebener Fahrzeuge am Verkehrsgeschehen nimmt beständig zu. Die vom Fahrzeug nutzbare elektrische Antriebsenergie wird dabei in einer Traktionsbatterie gespeichert. Um einer fahrzeugführenden Person zu vermitteln, wie weit mit der sich noch in der Traktionsbatterie befindlichen elektrischen Energiemenge gefahren werden kann, wird typischerweise eine Reichweiteninformation im Fahrzeug ausgegeben. Neben dieser Reichweiteninformation, beispielsweise in Form von einer Kilometerangabe, kann auch die von der Traktionsbatterie noch abrufbare elektrische Energiemenge selbst, beispielsweise in Form von Kilowattstunden, angezeigt werden. Auch kann die effektiv nutzbare elektrische Energiemenge in Bezug zur maximalen Kapazität der Traktionsbatterie, also beispielsweise in Form einer Prozentangabe, an die fahrzeugführende Person ausgegeben werden.

Es existieren regionsspezifische Richtlinien, Regularien und Normen, die die Ermittlung und Anzeige verschiedener batteriebezogener Parameter, wie beispielsweise den Alterungszustand, auch als State-of-Health (SOH) bezeichnet, oder den State-of-Certified-Energy (SOCE) zwingend erfordern. Zur Ermittlung dieser Größen sowie zur Sicherstellung des sicheren Betriebs der Traktionsbatterie, wird die Traktionsbatterie bzw. werden ihre Komponenten umfangreich überwacht. Beispielsweise wird die Zellkapazität, die Innenwiderstände, die Zellspannung und dergleichen gemessen und mit Referenzwerten verglichen. So ist es beispielsweise üblich die maximal zugelassene Entladetiefe einer Traktionsbatterie in Abhängigkeit der Temperatur zu ermitteln. Unter Berücksichtigung verschiedener Größen, wie der maximal nutzbaren Kapazität der Traktionsbatterie, des aktuellen Ladezustands der Traktionsbatterie und der erlaubten minimalen Entladetiefe, kann dann die Restreichweite sowie der State-of-Health berechnet werden. Wird die minimal erlaubte Entladetiefe unabhängig von der Alterung der Traktionsbatterie festgelegt, so weicht typischerweise die ermittelte in der Traktionsbatterie speicherbare bzw. noch verfügbare elektrische Energiemenge bzw. die entsprechende Restreichweite von der Realität ab. So wird meist für Neufahrzeuge eine zu geringe in der Traktionsbatterie vorgehaltene bzw. vorhaltbare elektrische Energiemenge und für gealterte Fahrzeuge ein zu hohe elektrische Energiemenge angenommen.

Es ist somit wünschenswert Mittel anzugeben, mit denen es möglich ist, die tatsächlich in einer Traktionsbatterie vorgehaltene bzw. maximal vorhaltbare elektrische Energiemenge anzugeben, auch unabhängig vom Alterungszustand des Fahrzeugs bzw. der Traktionsbatterie. Die strukturellen Änderungen am Fahrzeug sollten sich dabei auf ein Minimum beschränken, um die Herstellungskosten des Fahrzeugs nicht unverhältnismäßig ansteigen zu lassen. So sollten die Anforderungen an die Rechenleistung und den Speicher der im Fahrzeug verbauten Steuergeräte nicht steigen, um zu verhindern, dass komplexere und damit teurere Steuergeräte verbaut werden müssen.

Mittel zur Bestimmung der in einer Traktionsbatterie vorgehaltenen bzw. vorhaltbaren elektrischen Energiemenge sind beispielsweise aus der WO 2016/112960 A1 bekannt. Die Druckschrift beschreibt eine Rechenvorschrift zur Ermittlung der Restreichweite eines batterieelektrisch angetriebenen Fahrzeugs. Dabei werden Parameter in Form des elektrischen Widerstands, des Stroms sowie des minimalen und maximalen erlaubten Ladezustands der Traktionsbatterie berücksichtigt. Die jeweiligen Größen variieren in ihrer Höhe dabei von einem Modus, zu dem das Fahrzeug in der jeweiligen Situation betrieben wird. Beispielsweise können die Größen von der aktuell vorliegenden Ladeleistung abhängen. Wird beispielsweise eine im Vergleich hohe Ladeleistung bei einer kurzen Ladedauer gewählt, so kann die Traktionsbatterie nur zu einem geringeren maximalen Ladezustand geladen werden, als beim Durchführen eines Ladevorgangs mit einer geringeren Ladeleistung über eine längere Zeitspanne. Unter Berücksichtigung der sich in der jeweiligen Situation einstellenden oberen und unteren Ladezustandsgrenzen lässt sich dann genauer berechnen, welche elektrische Energiemenge in der Traktionsbatterie vorgehalten werden kann, um letztendlich die vom Fahrzeug erzielbare Restreichweite genauer abschätzen zu können.

Ferner ist aus der US 2017/0299660 A1 ein Verfahren zur Verwaltung des Betriebsbereichs einer Traktionsbatterie bekannt. Die Druckschrift beschreibt das Anpassen der jeweiligen gewählten oberen und unteren Ladezustandsgrenzwerte für eine Traktionsbatterie in Abhängigkeit der Alterung der Traktionsbatterie. So werden zu Beginn der Lebensdauer reduzierte Werte für die obere und untere Ladezustandsgrenze gewählt, die mit zunehmender Alterung erhöht werden. Da die Traktionsbatterie so zu Beginn ihrer Lebensdauer weniger stark vollgeladen wird, lässt sich ein Alterungsprozess verlangsamen. Mit zunehmendem Alter wird ein zu starkes Entladen der Traktionsbatterie verhindert. Über die Lebensdauer bleibt die Spreizung zwischen der unteren und oberen Ladezustandsgrenze ungefähr konstant, wodurch sich ein Nutzer an eine typische in der Traktionsbatterie vorhaltbare Energiemenge gewöhnen kann.

Der vorliegenden Erfindung liegt die Aufgabe zugrunde ein verbessertes Verfahren zur Schätzung der von einer Traktionsbatterie eines Fahrzeugs speicherbaren elektrischen Energiemenge anzugeben, mit dessen Hilfe die speicherbare elektrische Energiemenge besonders zuverlässig abgeschätzt werden kann.

Erfindungsgemäß wird diese Aufgabe durch ein computerimplementiertes Verfahren zur Schätzung der von einer Traktionsbatterie eines Fahrzeugs speicherbaren elektrischen Energiemenge mit den Merkmalen des Anspruchs 1 gelöst. Vorteilhafte Ausgestaltungen und Weiterbildungen sowie ein Computerprogrammprodukt, ein computerlesbares Speichermedium und ein Fahrzeug zur Durchführung des Verfahrens ergeben sich aus den hiervon abhängigen Ansprüchen.

Ein gattungsgemäßes computerimplementiertes Verfahren zur Schätzung der von einer Traktionsbatterie eines Fahrzeugs speicherbaren elektrischen Energiemenge, wobei eine fahrzeuginterne Recheneinheit zur Bestimmung der elektrischen Energiemenge eine Batteriekapazität der Traktionsbatterie mit dem Integral der Batteriespannung der Traktionsbatterie von einer unteren Ladezustandsgrenze bis zu einer oberen Ladezustandsgrenze multipliziert, wobei für die untere Ladezustandsgrenze ein von der Alterung der Traktionsbatterie abhängiger Wert angenommen wird, wir erfindungsgemäß dadurch weitergebildet, dass die Recheneinheit die untere Ladezustandsgrenze durch eine lineare Korrelation zum Verhältnis der aktuellen maximalen Batteriekapazität zur ursprünglichen maximalen Batteriekapazität der Traktionsbatterie unter Berücksichtigung wenigstens eines Parameters bestimmt, wobei die von der Alterung abhängige Höhe des wenigstens einen Parameters durch Analyse historischer Batteriedaten von Lade- und/oder Entladevorgängen baugleicher Traktionsbatterien festgelegt wird.

Die Anmelderin hat überraschendweise festgestellt, dass ein einfacher linearer Zusammenhang zwischen dem Verhältnis der aktuellen, also alterungsbedingt verminderten, maximalen Batteriekapazität zur ursprünglichen maximalen Batteriekapazität zur unteren Ladezustandsgrenze existiert. Dies ermöglicht es eine alterungsabhängige untere Ladezustandsgrenze auf mathematisch besonders einfache Art und Weise zu ermitteln. Die Anforderungen an die Recheneinheit bezüglich Rechenleistung und Speicher fallen somit gering aus, sodass besonders einfache Recheneinheiten im Fahrzeug verbaut werden können, um die in der Traktionsbatterie maximal vorhaltbare, bzw. aktuell noch abrufbare elektrische Energiemenge, und damit die Restreichweite, abzuschätzen. Zudem ist es möglich eine besonders genaue Schätzung der in der Traktionsbatterie speicherbaren elektrischen Energiemenge vorzunehmen, da die Alterung der Traktionsbatterie berücksichtigt wird. Somit lassen sich besonders genaue Schätzungen für die Reichweite des Fahrzeugs machen. Insbesondere wird so vermieden, dass für Neufahrzeuge eine zu geringe Batteriekapazität und für ältere Fahrzeuge eine zu hohe Batteriekapazität angenommen wird.

Dabei können bewährte Ermittlungsverfahren zur Bestimmung der aktuellen maximalen Batteriekapazität eingesetzt werden. Der hierdurch zu Beginn der Einsatzphase des Fahrzeugs ermittelte Wert kann als ursprüngliche maximale Batteriekapazität gespeichert werden. Der jeweils aktuell gemessene Wert, bzw. das Verhältnis, stellt dann die aktuelle, also die alterungsbedingt verminderte, maximale Batteriekapazität dar. Diese Größen werden mit besagtem Parameter verrechnet, der durch Analyse historischer Batteriedaten ermittelt wird, beispielsweise im Zuge der Entwicklung des Fahrzeugs oder seiner Komponenten.

Bei der Entwicklung und Erprobung besagter Fahrzeuge fallen ohnehin Batteriedaten an. Die Batteriedaten beschreiben alle sensorisch überwachten sowie mit Hilfe von Rechenmodellen abgeschätzten Batterieparameter während dem Durchführen der besagten Lade- und/oder Entladevorgängen. Hierzu zählen beispielsweise Spannungswerte, Stromstärkewerte, Widerstandswerte, Temperaturen und dergleichen sowie daraus abgeleitete Größen, wie Kapazitäten, ein Ladezustand, ein Batteriealterungsindikator wie der SOH und dergleichen. Jeweilige Werte können für die einzelnen Komponenten der Traktionsbatterie, wie beispielsweise einzelne galvanische Zellen, oder auch für Module, wie Batteriemodule, oder sogar für die gesamte Traktionsbatterie bestimmt werden. Durch Data Mining lassen sich dann aus den Batteriedaten Zusammenhänge zwischen den jeweiligen Einflussparametern und dem wenigstens einen zu ermittelnden Parameter, der zur Bestimmung der alterungsabhängigen unteren Ladezustandsgrenze verwendet wird, ermitteln. Für das Data Mining können alle bewährten Methoden der Datenanalyse und Musteridentifikation eingesetzt werden.

Eine vorteilhafte Weiterbildung des erfindungsgemäßen Verfahrens sieht dabei vor, dass die untere Ladezustandsgrenze durch folgende Formel festgelegt wird:

$$SOC_{low} = SOC_0 + SOC_{alterung} * (100 - SOH_c);$$

wobei:

- $SOC_{low}$ der unteren Ladezustandsgrenze entspricht;
- $SOC_0$ einem ersten durch Analyse der historischen Batteriedaten festzulegendem Parameter entspricht;
- $SOC_{alterung}$ einem zweiten durch Analyse der historischen Batteriedaten festzulegendem Parameter entspricht; und
- $SOH_c$ dem Verhältnis der aktuellen maximalen Batteriekapazität zur ursprünglichen maximalen Batteriekapazität in Prozent entspricht. Insbesondere wird das Minimum aller Zellkapazitäten oder eine berechnete Batteriekapazität und der nominelle Wert der Batteriekapazität zur Berechnung herangezogen.

Somit ist eine besonders einfache und dabei doch genaue Formel zur Festlegung der alterungsabhängigen unteren Ladezustandsgrenze angegeben.

Entsprechend einer weiteren vorteilhaften Ausgestaltung des erfindungsgemäßen Verfahrens bestimmt die Recheneinheit die untere Ladezustandsgrenze für jede galvanische Zelle der Traktionsbatterie individuell. Dies ermöglicht es die untere Ladezustandsgrenze in Abhängigkeit der Batteriealterung noch zuverlässiger zu bestimmen. Dadurch, dass eine genauere untere Ladezustandsgrenze ermittelt werden kann, kann auch die in der Traktionsbatterie vorgehaltene bzw. vorhaltbare elektrische Energiemenge zuverlässiger und damit genauer ermittelt werden. Somit kann letztendlich auch eine noch genauere Reichweite für das batterieelektrisch angetriebene Fahrzeug ermittelt werden. Unter Berücksichtigung der maximalen Kapazität der Traktionsbatterie kann dann die maximale Reichweite bestimmt werden und unter Berücksichtigung des aktuellen Ladezustands die noch zur Verfügung stehende Restreichweite.

Eine weitere vorteilhafte Ausgestaltung des erfindungsgemäßen Verfahrens sieht dabei ferner vor, dass die Recheneinheit eine temperaturabhängige untere Ladezustandsgrenze bestimmt. Dies ist auf unterschiedliche Art und Weise möglich. Beispielsweise kann der wenigstens eine Parameter, insbesondere die beiden Parameter in Form von $SOC_0$ und $SOC_{alterung}$ temperaturabhängig ermittelt werden. Beispielsweise kann ein formelmäßiger Zusammenhang zwischen der Temperatur, beispielsweise der Umgebungstemperatur oder der Temperatur einer Komponente oder Baugruppe der Traktionsbatterie, zu den jeweiligen Parametern festgelegt werden. Für die aus der Analyse der historischen Batteriedaten ermittelten Parameter können dann entsprechende Zusammenhänge in Form von Tabellen oder Kennfeldern in der Recheneinheit gespeichert werden. Die Analyse der historischen Batteriedaten kann dabei extern zum Fahrzeug erfolgen. Beispielsweise könnte die im vorigen beschriebene Gleichung mit einem temperaturabhängigen Skalierungsfaktor multipliziert werden.

Entsprechend einer weiteren vorteilhaften Ausgestaltung des erfindungsgemäßen Verfahrens wird künstliche Intelligenz zur Analyse der historischen Batteriedaten eingesetzt. Hierzu können bewährte Machine-Learning Algorithmen eingesetzt werden. Insbesondere erfolgt die Datenanalyse unter Einsatz eines künstlichen neuronalen Netzes. Mit Hilfe von künstlicher Intelligenz lassen sich besonders zuverlässig Muster auch in umfangreichen Datensätzen auffinden. Dies ermöglicht es zuverlässig die Höhe der besagten Einflussparameter zur Bestimmung der alterungsabhängigen unteren Ladezustandsgrenze aufzufinden.

Ein erfindungsgemäßes Computerprogrammprodukt umfasst maschineninterpretierbare Anweisungen, die bei einer Ausführung durch einen Prozessor eine den Prozessor umfassende Recheneinheit zur Bereitstellung eines im vorigen beschriebenen Verfahrens befähigen.

Das besagte Computerprogrammprodukt wird dabei auf einem erfindungsgemäßen computerlesbaren Speichermedium vorgehalten.

Ein erfindungsgemäßes Fahrzeug umfasst eine Recheneinheit mit einem Lesezugriff auf besagtes computerlesbares Speichermedium. Bei dem Fahrzeug kann es sich um ein beliebiges batterieelektrisch angetriebenes Straßenfahrzeug wie einen Pkw, Lkw, Transporter, Bus oder dergleichen handeln. Das Fahrzeug kann rein batterieelektrisch angetrieben sein oder auch als Hybridfahrzeug, insbesondere Plugin-Hybridfahrzeug, ausgeführt sein.

Weitere vorteilhafte Ausgestaltungen des erfindungsgemäßen Verfahrens zur Schätzung der von der Traktionsbatterie des Fahrzeugs speicherbaren elektrischen Energiemenge ergeben sich auch aus den Ausführungsbeispielen, welche nachfolgend unter Bezugnahme auf die Figuren näher beschrieben werden.

Dabei zeigen:

Fig. 1    ein Diagramm, zeigend die von der Traktionsbatterie eines Fahrzeugs abgegebenen Spannung in Abhängigkeit des Ladezustands der Traktionsbatterie;

Fig. 2    eine erste Gleichung, zeigend eine Rechenvorschrift zur Bestimmung der in der Traktionsbatterie speicherbaren elektrischen Energiemenge;

Fig. 3    eine zweite Gleichung, zeigend eine Rechenvorschrift zur Bestimmung einer alterungsabhängigen unteren Ladezustandsgrenze;

Fig. 4    ein Diagramm, zeigend die abgeschätzte in der Traktionsbatterie speicherbare elektrische Energiemenge in Abhängigkeit eines Alterungszustands der Traktionsbatterie.

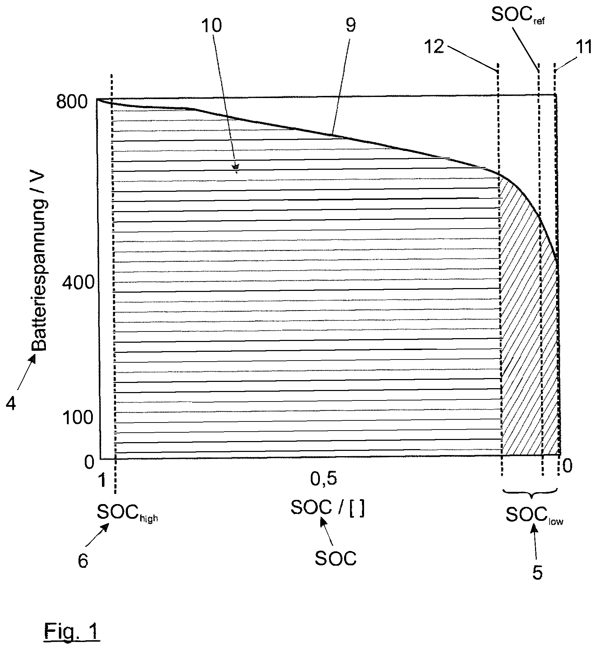

Die insgesamt in einer Traktionsbatterie eines Fahrzeugs speicherbare elektrische Energiemenge ist von der Größe der sich unter der in Figur 1 eingezeichneten Kurve 9 befindlichen Fläche 10 abhängig. Dabei entspricht die Kurve 9 der von der Traktionsbatterie eines batterieelektrisch angetriebenen Fahrzeugs abgegebenen Batteriespannung 4 (hier Entladespannung), welche in dem in Figur 1 gezeigten Diagramm über dem dimensionslosen Ladezustand SOC aufgetragen ist. Ein Ladezustand SOC von 1 entspricht dabei einer voll aufgeladenen Traktionsbatterie und ein Ladezustand SOC von 0 einer vollständig entladenen Traktionsbatterie. Die von der Traktionsbatterie abgebbare Batteriespannung 4 fällt dabei mit zunehmender Entladung der Traktionsbatterie ab.

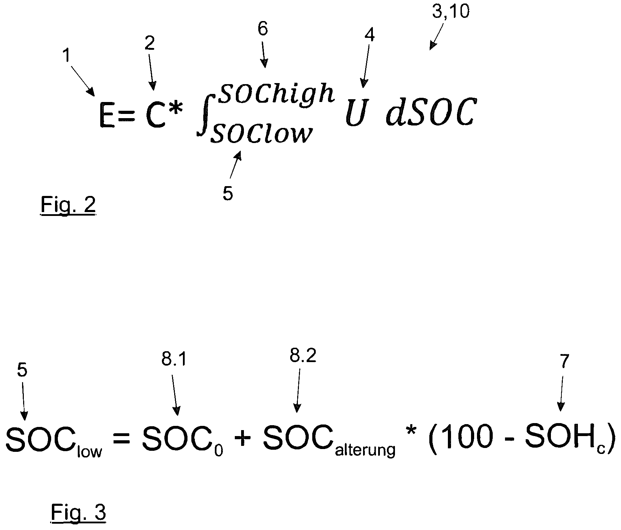

Zur Bestimmung der insgesamt in der Traktionsbatterie vorhaltbaren elektrischen Energiemenge 1 dient die in Figur 2 gezeigte Gleichung. Dabei wird die Batteriekapazität 2 mit dem Integral 3 der Batteriespannung 4 der Traktionsbatterie von einer unteren Ladezustandsgrenze 5 bis zu einer oberen Ladezustandsgrenze 6 multipliziert. Die untere Ladezustandsgrenze 5 ist in den Gleichungen und den Diagrammen mit $SOC_{low}$ und die obere Ladezustandsgrenze 6 mit $SOC_{high}$ bezeichnet.

Bisher wurde dabei eine von der Alterung der Traktionsbatterie unabhängige untere Ladezustandsgrenze verwendet, welche in Figur 1 mit dem Bezugszeichen $SOC_{ref}$ bezeichnet ist. Tatsächlich wird sich diese Ladezustandsgrenze jedoch in Abhängigkeit der Alterung verschieben. Der mögliche Bereich in dem sich diese tatsächliche untere Ladezustandsgrenze 5 bewegen kann, ist in Figur 1 durch eine schräge Schraffur angedeutet. So ist es möglich die Traktionsbatterie zu Beginn ihrer Lebensdauer weiter zu entladen, was durch eine Grenze 11 angedeutet ist. Eine gealterte Traktionsbatterie kann hingegen weniger stark entladen werden, was durch eine Grenze 12 angedeutet ist. Entsprechend ändert sich auch der Flächeninhalt der Fläche 10. Dies bedeutet, dass bei Annahme einer über die Alterung konstanten unteren Ladezustandsgrenze $SOC_{ref}$, die untere Ladezustandsgrenze 5 für eine neue Traktionsbatterie unterschätzt und für eine gealterte Traktionsbatterie überschätzt wird. Die sich daraus entsprechend ergebende in der Traktionsbatterie vorhaltbare elektrische Energiemenge wird somit von der Realität abweichen. An dieser Stelle setzt das erfindungsgemäße Verfahren zur Schätzung der von der Traktionsbatterie speicherbaren elektrischen Energiemenge 1 an, welches durch das Berücksichtigen des Einflusses der Alterung auf die tatsächliche Höhe der unteren Ladezustandsgrenze 5 dazu in der Lage ist, die elektrische Energiemenge 1 genauer abzuschätzen.

Unter Berücksichtigung historischer Batteriedaten baugleicher Traktionsbatterien werden die Parameter 8.1 und 8.2 einer linearen Korrelation zwischen der unteren Ladezustandsgrenze 5 zum in Figur 3 gezeigten Verhältnis 7 aus der aktuellen maximalen Batteriekapazität und der ursprünglichen maximalen Batteriekapazität bestimmt. Diese lineare Korrelation kann besonders vorteilhaft durch die in Figur 3 gezeigte Gleichung beschrieben werden. Dabei werden ein erster Parameter 8.1 und ein zweiter Parameter 8.2 durch Analyse der historischen Batteriedaten festgelegt. Die untere Ladezustandsgrenze 5 ergibt sich entsprechend durch Summation des ersten Parameters 8.1 mit dem Produkt aus dem zweiten Parameter 8.2 und dem Verhältnis 7 der alterungsbedingt reduzierten maximalen Batteriekapazität.

Beispielsweise durch umfassende Laboranalysen, Messkampagnen im Feld und/oder Simulationen kann für die jeweiligen Traktionsbatterien auf denen die historischen Batteriedaten beruhen die tatsächliche Batteriekapazität in Abhängigkeit der Alterung, beispielsweise des SOH, ermittelt werden. Dies erlaubt es die tatsächliche untere Ladezustandsgrenze 5 zu ermitteln. Die in Figur 3 gezeigte Gleichung kann dann zur Ermittlung für die gesuchten Parameter 8.1 und 8.2 umgestellt werden. Unter Berücksichtigung einer Vielzahl baugleicher Traktionsbatterien zu verschiedenen Alterungszuständen können somit alle gesuchten Parameter 8.1, 8,2 über das gesamte Kennfeld bestimmt werden.

Da es sich bei der in der Figur 3 gezeigten Gleichung um eine Funktion zur Beschreibung einer Geraden handelt, also eine lineare Korrelation, lässt sich die alterungsabhängige untere Ladezustandsgrenze 5 mathematisch mit geringem Aufwand ermitteln. Entsprechend recheneffizient ist dies möglich. Das erfindungsgemäße Verfahren kann somit auf einer Recheneinheit ausgeführt werden, an die nur geringe Anforderungen bezüglich der Rechenleistung und den verbauten Speicher gestellt werden.

Der erste Parameter 8.1 in Form von $SOC_0$ kann beispielsweise Werte im Bereich von -4 bis +1 annehmen. Der zweite Parameter 8.2 in Form von $SOC_{alterung}$ kann beispielsweise Werte im Bereich von 0 bis 1 annehmen.

Die Alterung der Traktionsbatterie kann auf bewährte Art und Weise beschrieben werden. So können bewährte Methoden zum Abschätzen des Alterungszustands bzw. des State-of-Health eingesetzt werden. So kann die Kapazität z.B. mittels Dreisatz aus der zwischen zwei, durch Ruhespannungsmessungen bekannten, Ladezuständen geflossenen Ladung bestimmt werden. Dies erlaubt es die aktuelle minimale oder maximale Batteriekapazität und damit auch das Verhältnis 7 zu ermitteln.

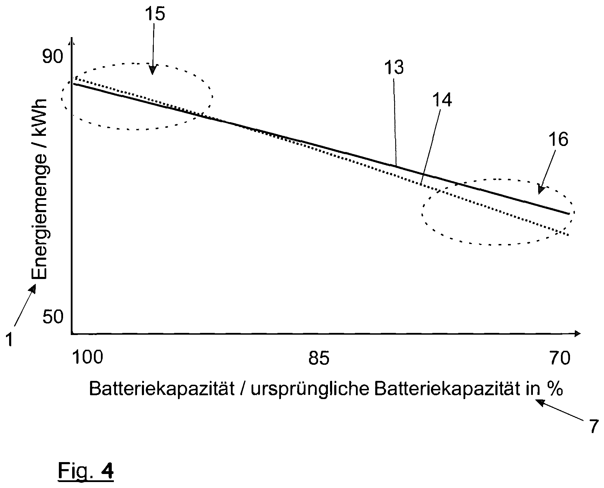

Der Vorteil durch den Einsatz des erfindungsgemäßen computerimplementierten Verfahrens wird durch das in Figur 4 dargestellte Diagramm veranschaulicht. Das in Figur 4 dargestellte Diagramm zeigt die geschätzte in der Traktionsbatterie des Fahrzeugs vorhaltbare (Aufladen der Traktionsbatterie bis zum maximalen Ladezustand) elektrische Energiemenge 1 über dem Alterungsgrad der Traktionsbatterie. Der Alterungsgrad ist dabei ausgedrückt als das Verhältnis der aktuell verfügbaren maximalen Kapazität zur nominal vorhandenen, also der ursprünglichen maximalen Kapazität der Traktionsbatterie, also dem Verhältnis 7.

Eine durchgezogene Linie 13 zeigt dabei die unter Berücksichtigung einer alterungsunabhängigen unteren Ladezustandsgrenze ermittelte Energiemenge und eine gestrichelte Linie 14 die mit Hilfe der alterungsabhängig ermittelten unteren Ladezustandsgrenze 5 geschätzte elektrische Energiemenge 1.

Wie das Diagramm zeigt, erlaubt es die Berücksichtigung einer alterungsabhängigen unteren Ladezustandsgrenze 5 in einem Bereich 15 für junge Traktionsbatterien eine höhere elektrische Energiemenge und einem Bereich 16 für gealterte Traktionsbatterien eine geringere maximal vorhaltbare elektrische Energiemenge 1 zu ermitteln. Somit ist es also möglich eine genauere, das heißt dem Alterungszustand entsprechende, maximal vorhaltbare elektrische Energiemenge 1 für die Traktionsbatterie zu ermitteln. Somit kann auch die für das Fahrzeug ermittelte Restreichweite noch genauer ermittelt werden. Hierzu kann anstelle der oberen Ladezustandsgrenze 6 der aktuelle Ladezustand der Traktionsbatterie verwendet werden.

**Patentansprüche**

1. Computerimplementiertes Verfahren zur Schätzung der von einer Traktionsbatterie eines Fahrzeugs speicherbaren elektrischen Energiemenge (1), wobei eine fahrzeuginterne Recheneinheit zur Bestimmung der elektrischen Energiemenge (1) eine Batteriekapazität (2) der Traktionsbatterie mit dem Integral (3) der Batteriespannung (4) der Traktionsbatterie von einer unteren Ladezustandsgrenze (5) bis zu einer oberen Ladezustandsgrenze (6) multipliziert, wobei für die untere Ladezustandsgrenze (5) ein von der Alterung der Traktionsbatterie abhängiger Wert angenommen wird,
   **dadurch gekennzeichnet, dass**
   die Recheneinheit die untere Ladezustandsgrenze (5) durch eine lineare Korrelation zum Verhältnis (7) der aktuellen maximalen Batteriekapazität zur ursprünglichen maximalen Batteriekapazität der Traktionsbatterie unter Berücksichtigung wenigstens eines Parameters bestimmt, wobei die von der Alterung abhängige Höhe des wenigstens einen Parameters (8.1, 8.2) durch Analyse historischer Batteriedaten von Lade- und/oder Entladevorgängen baugleicher Traktionsbatterien festgelegt wird.

2. Verfahren nach Anspruch 1,
   **dadurch gekennzeichnet, dass**

   die untere Ladezustandsgrenze (5) durch folgende Formel festgelegt wird:

   $$SOC_{low} = SOC_0 + SOC_{alterung} * (100 - SOH_c);$$

   wobei:

   - $SOC_{low}$ der unteren Ladezustandsgrenze (5) entspricht;
   - $SOC_0$ einem ersten durch Analyse der historischen Batteriedaten festzulegendem Parameter (8.1) entspricht;
   - $SOC_{alterung}$ einem zweiten durch Analyse der historischen Batteriedaten festzulegendem Parameter (8.2) entspricht; und
   - $SOH_c$ dem Verhältnis (7) der aktuellen maximalen Batteriekapazität zur ursprünglichen maximalen Batteriekapazität in Prozent entspricht.

3. Verfahren nach Anspruch 1,
   **dadurch gekennzeichnet, dass**
   die untere Ladezustandsgrenze (5) durch ein Polynom festgelegt wird, welches den SOHc, den relativen Innenwiderstandsanstieg und den Energiedurchsatz als Faktoren mit verschiedenen Potenzen mit festlegbaren Vorfaktoren enthält.

4. Verfahren nach Anspruch 3,

   **dadurch gekennzeichnet, dass**
   das Polynom Wechselwirkungsterme mit festlegbaren Vorfaktoren enthält.

5. Verfahren nach einem der Ansprüche 1 bis 4,
   **dadurch gekennzeichnet, dass**
   die Recheneinheit die untere Ladezustandsgrenze (5) für jede galvanische Zelle der Traktionsbatterie individuell bestimmt.

6. Verfahren nach einem der Ansprüche 1 bis 5,
   **dadurch gekennzeichnet, dass**
   die Recheneinheit eine temperaturabhängige untere Ladezustandsgrenze (5) bestimmt.

7. Verfahren nach einem der Ansprüche 1 bis 6
   **dadurch gekennzeichnet, dass**
   künstliche Intelligenz zur Analyse der historischen Batteriedaten eingesetzt wird.

8. Computerprogrammprodukt,
   **gekennzeichnet durch**
   maschineninterpretierbare Anweisungen, die bei einer Ausführung durch einen Prozessor eine den Prozessor umfassende Recheneinheit zur Bereitstellung eines Verfahrens nach einem der Ansprüche 1 bis 7 befähigen.

9. Computerlesbares Speichermedium,
   **gekennzeichnet durch**
   ein Computerprogrammprodukt nach Anspruch 8.

10. Fahrzeug,
    **gekennzeichnet durch**
    eine Recheneinheit mit einem Lesezugriff auf ein computerlesbares Speichermedium nach Anspruch 9.

Fig. 1

$$E = C * \int_{SOClow}^{SOChigh} U \; dSOC$$

Fig. 2

$$SOC_{low} = SOC_0 + SOC_{alterung} * (100 - SOH_c)$$

Fig. 3

**Fig. 4**

**Europäisches Patentamt**
**European Patent Office**
**Office européen des brevets**

# EUROPÄISCHER RECHERCHENBERICHT

Nummer der Anmeldung

EP 25 17 6715

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2017/355276 A1 (CHANG XIAOGUANG [US] ET AL) 14. Dezember 2017 (2017-12-14) * das ganze Dokument * ----- | 1-10 | INV. G01R31/36 G01R31/367 G01R31/374 G01R31/382 |
| A | DE 10 2021 109317 A1 (MAN TRUCK & BUS SE [DE]) 20. Oktober 2022 (2022-10-20) * das ganze Dokument * ----- | 1-10 | |
| A | DE 10 2022 115102 A1 (BAYERISCHE MOTOREN WERKE AG [DE]) 21. Dezember 2023 (2023-12-21) * das ganze Dokument * ----- | 1-10 | |
| A,D | US 2017/299660 A1 (SAINT-MARCOUX ANTOINE [FR] ET AL) 19. Oktober 2017 (2017-10-19) * das ganze Dokument * ----- | 1-10 | |

**RECHERCHIERTE SACHGEBIETE (IPC)**

G01R
H02J
B60L

Der vorliegende Recherchenbericht wurde für alle Patentansprüche erstellt

| Recherchenort | Abschlußdatum der Recherche | Prüfer |
|---|---|---|
| München | 7. Oktober 2025 | Nguyen, Minh |

EPO FORM 1503 03.82 (P04C03)

**EP 4 653 887 A1**

**ANHANG ZUM EUROPÄISCHEN RECHERCHENBERICHT
ÜBER DIE EUROPÄISCHE PATENTANMELDUNG NR.**  EP 25 17 6715

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-10-2025

| Im Recherchenbericht angeführtes Patentdokument | Datum der Veröffentlichung | Mitglied(er) der Patentfamilie | Datum der Veröffentlichung |
|---|---|---|---|
| US 2017355276 A1 | 14-12-2017 | CN 107472049 A<br>DE 102017112297 A1<br>US 2017355276 A1 | 15-12-2017<br>14-12-2017<br>14-12-2017 |
| DE 102021109317 A1 | 20-10-2022 | DE 102021109317 A1<br>WO 2022218927 A1 | 20-10-2022<br>20-10-2022 |
| DE 102022115102 A1 | 21-12-2023 | CN 118871318 A<br>DE 102022115102 A1<br>US 2025206187 A1<br>WO 2023241895 A1 | 29-10-2024<br>21-12-2023<br>26-06-2025<br>21-12-2023 |
| US 2017299660 A1 | 19-10-2017 | CN 107078520 A<br>EP 3191337 A1<br>FR 3025663 A1<br>JP 6585164 B2<br>JP 2017535230 A<br>KR 20170057314 A<br>US 2017299660 A1<br>WO 2016038276 A1 | 18-08-2017<br>19-07-2017<br>11-03-2016<br>02-10-2019<br>24-11-2017<br>24-05-2017<br>19-10-2017<br>17-03-2016 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016112960 A1
- US 20170299660 A1